# FASCICULE DE BREVET EUROPEEN

(11) **EP 1 554 799 B1**
(45) Date de publication et mention de la délivrance du brevet: **14.05.2008**
(21) Numéro de dépôt: 03755998.6
(22) Date de dépôt: 16.05.2003
(51) Int. Cl.: H03F 1/00

(54) **AMPLIFICATEUR HAUTE FREQUENCE EN CIRCUIT INTEGRE**
INTEGRIERTE HF-VERSTÄRKERSCHALTUNG
HIGH FREQUENCY AMPLIFIER IN AN INTEGRATED CIRCUIT

(30) Priorité: 31.05.2002 FR 0206723
(43) Date de publication de la demande: 20.07.2005
(73) Titulaire: E2V Semiconductors, 38120 Saint Egreve (FR)
(72) Inventeur: DEBROUX, Jean-François Thales Intellectual Proper., F-94117 Arcueil Cedex (FR)
(74) Mandataire: Guérin, Michel
(86) Numéro de dépôt international: PCT/FR2003/001504
(87) Numéro de publication internationale: WO 2003/103133

(56) Documents cités:
- WO-A-02/01709
- US-A- 4 661 781
- US-A- 5 159 286
- US-A- 5 828 269

## Description

L'invention concerne les amplificateurs réalisés en circuit intégré sur silicium et capables de fournir des puissances de l'ordre de quelques centaines de milliwatts à des fréquences de l'ordre d'un gigahertz ou plus, en amplifiant un signal d'entrée avec un gain d'au moins 20 à 30 dB et avec un rendement suffisant (par exemple supérieur à 30%). Le document US-A-5159286 décrit un amplificateur réalisé sous forme intégrée.

Les applications de tels amplificateurs sont notamment l'émission radiofréquence à faible puissance à l'aide de circuits très peu encombrants et le moins coûteux possible. Pour rendre l'amplificateur aussi peu encombrant que possible, il est souhaitable de le réaliser à l'aide d'un circuit intégré unique auquel on associe un nombre réduit de composants externes. Un facteur de coût est en effet la présence dé composants externes, non seulement en raison de leur coût propre et de leur coût de montage, mais surtout en raison du fait qu'il faut prévoir des broches d'accès supplémentaires du circuit intégré uniquement pour connecter ces composants en des points internes de l'amplificateur.

Un amplificateur travaillant à des fréquences radio nécessiterait normalement plusieurs étages d'amplification et en général des inductances et capacités d'adaptation entre les étages. Aux fréquences radio envisagées (de l'ordre de 1 GHz à quelques GHz) ces inductances et capacités seraient trop encombrantes pour être intégrées dans la puce de circuit-intégré au silicium. Il faudrait donc normalement des broches d'accès spécifiques du circuit intégré, permettant de connecter des capacités et inductances extérieures pour les adaptations d'impédance entre étages.

Un but de l'invention est donc de proposer un schéma d'amplificateur radiofréquence qui ne nécessite pas de capacité et d'inductance d'adaptation entre étages.

Pour cela, on propose un circuit intégré comportant un amplificateur dont le dernier étage comprend deux points d'entrée de signal à amplifier E et E' recevant en différentiel un signal à amplifier, et quatre transistors principaux de même type de conductivité, ayant chacun une base, un émetteur et un collecteur, parmi lesquels un premier transistor ou transistor de sortie monté en émetteur commun, dont le collecteur est relié à une sortie du circuit intégré, un deuxième transistor monté en suiveur de tension entre le point E et la base du transistor de sortie, un troisième transistor monté en émetteur commun, ayant son collecteur relié à la base du transistor de sortie, un quatrième transistor monté en suiveur de tension ayant sa base reliée au point E' et son émetteur relié à la base du troisième transistor, le circuit comprenant encore une première source de courant reliée à la base du premier transistor et une deuxième source de courant reliée à la base du troisième transistor.

Au lieu d'utiliser des inductances et capacités d'adaptation en amont d'un transistor de sortie, on utilise donc un circuit à deux transistors (deuxième et troisième transistors) de même polarité, fonctionnant à la manière d'un étage push-pull.

L'invention est applicable de manière plus avantageuse si les transistors mentionnés ci-dessus sont des transistors bipolaires. Toutefois, on peut envisager de la mettre en oeuvre également avec des transistors à effet de champ MOS, et dans ce cas on considérera, pour une définition générale de l'invention avec le vocabulaire simple des transistors bipolaires, que les mots base, émetteur et collecteur désignent respectivement la grille, la source et le drain du transistor MOS.

De préférence, la taille du premier transistor est N fois plus grande que celle du troisième transistor et la taille du deuxième transistor est dans le même rapport N avec le quatrième transistor, les première et deuxième sources fournissant des courants dans le même rapport N.

On prévoit de préférence un cinquième transistor, ayant sa base polarisée par une tension fixe, son émetteur relié à la masse par une résistance, et son collecteur relié à la base du troisième transistor et à l'émetteur du quatrième. Il a de préférence une taille N fois plus faible que celle du troisième transistor. Le rapport N est choisi relativement élevé, par exemple égal à 8 ou 16, pour réduire la taille des deuxième, troisième, quatrième et cinquième transistors et leurs courants de repos dans le même rapport, la taille du premier transistor étant dictée par le courant de sortie désiré, donc par la puissance de sortie désirée.

De préférence encore, l'amplificateur selon l'invention comporte deux demi-amplificateurs identiques, commandés par des tensions d'entrée différentielles identiques mais en opposition de phase. Le circuit intégré comporte alors deux sorties et ces sorties fournissent chacune, en opposition de phase, la moitié de la puissance de sortie désirée. Ces sorties peuvent être réunies à l'extérieur du circuit intégré par un circuit de couplage qui regroupe, en les mettant en phase et en adaptant éventuellement l'impédance, les courants fournis par les deux sorties.

Le circuit intégré selon l'invention peut inclure d'autres éléments que l'amplificateur de sortie. Dans une application particulière, le circuit intégré est un synthétiseur de fréquence, comprenant un oscillateur à fréquence contrôlée et l'amplificateur. Il établit alors une fréquence radio désirée, l'amplifie et la fournit à sa sortie à une puissance de plusieurs centaines de milliwatts.

D'autres caractéristiques et avantages de l'invention apparaîtront à la lecture de la description détaillée qui suit et qui est faite en référence aux dessins annexés dans lesquels :
- la figure 1 représente le schéma de principe de l'amplificateur selon l'invention ;
- la figure 2 représente un amplificateur constitué par l'association de deux étages amplificateurs travaillant en opposition de phase, leurs sorties étant couplées à travers un coupleur hybride.

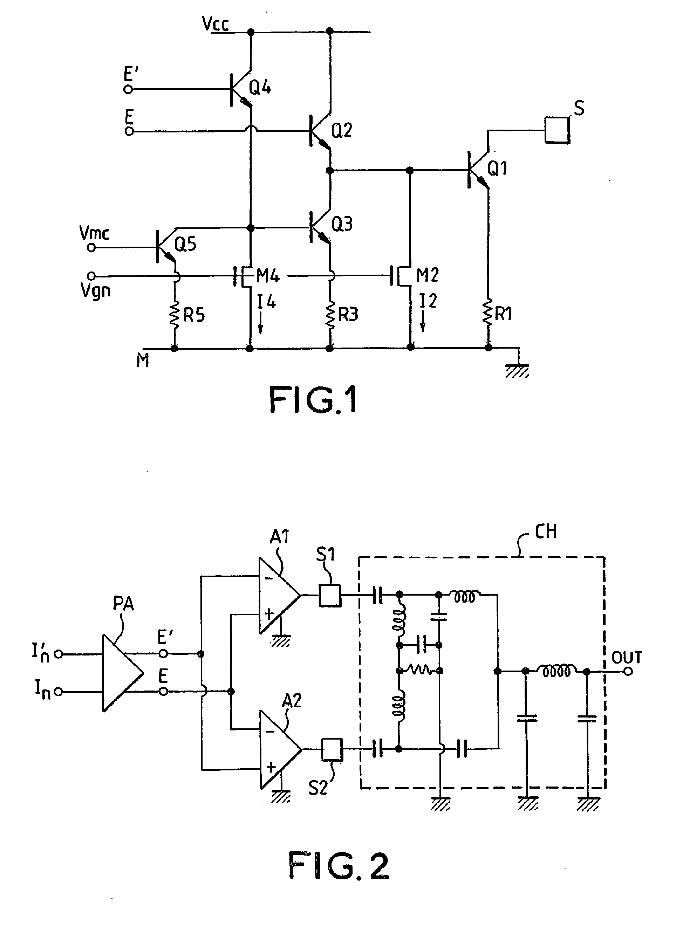

Sur la figure 1, on voit le dernier étage de l'amplificateur selon l'invention. Les étages précédents, s'il y en a, ne posent pas de problème particulier et ne seront pas décrits. Ils fournissent au dernier étage un signal différentiel à amplifier, entre deux points d'entrée E et E' du dernier étage.

Les entrées E et E' voient leurs potentiels varier en opposition de phase autour d'un potentiel de mode commun Vmc défini par la polarisation de sortie de l'étage précédent le dernier étage.

Le dernier étage de l'amplificateur comporte essentiellement quatre transistors Q1 à Q4 dont on va décrire les connexions et les fonctions. Il comporte de préférence également un cinquième transistor auxiliaire Q5.

Dans la réalisation préférentielle qui est décrite ici, la technologie de circuit intégré utilisée est une technologie mixte bipolaire et CMOS (technologie BiCMOS). Dans ce cas les cinq transistors Q1 à Q5 sont des transistors bipolaires. Ce n'est que dans le cas où la technologie utilisée serait purement MOS ou CMOS que ces transistors seraient obligatoirement des transistors à effet de champ.

Le premier transistor Q1 est le transistor de sortie de l'amplificateur. Son collecteur est relié à une broche de sortie S du circuit intégré. Ce transistor est monté en émetteur commun (commande par la base, émetteur relié par une résistance R1 à une masse M du circuit, sortie sur le collecteur).

La base du transistor Q1 est commandée simultanément par l'émetteur du deuxième transistor Q2 et le collecteur du troisième transistor Q3. Le deuxième transistor Q2 fournit un courant entrant croissant à la base du transistor de sortie Q1 lorsque la tension d'entrée en E croît et la tension en E' décroît. Le troisième transistor Q3 tire un courant croissant hors de la base du transistor de sortie Q1 dans le cas contraire, c'est-à-dire lorsque la tension d'entrée en E décroît et la tension en E' croît.

La base du deuxième transistor Q2 est reliée directement au point d'entrée E. Le transistor Q2 est monté en suiveur (entrée sur la base, sortie sur l'émetteur, collecteur de préférence directement relié à une alimentation positive Vcc). Son émetteur est relié directement à la base du transistor de sortie Q1.

Le troisième transistor Q3 est monté en émetteur commun (commande par la base, émetteur relié par une résistance R3 à la masse M, sortie sur le collecteur relié à la base du transistor de sortie Q1). Ce troisième transistor a sa base reliée à l'émetteur du quatrième transistor Q4 pour être commandé par ce dernier.

Le quatrième transistor Q4 est monté en suiveur (entrée sur la base, sortie sur l'émetteur, collecteur relié à l'alimentation Vcc). Sa base est reliée à l'entrée E'. Son émetteur est relié à la base du troisième transistor Q3.

Pour le fonctionnement correct, en suiveur de tension, des transistors Q2 et Q4, on prévoit de préférence que leurs émetteurs sont reliés chacun par une source de courant constant respective reliée à la masse M. Chaque source de courant est de préférence constituée par un transistor MOS respectif. Pour le transistor Q2 la source de courant est un transistor MOS M2 connecté entre l'émetteur de Q2 et la masse M et fournissant un courant 12 ; ce transistor M2 a sa base commandée par un potentiel constant Vgn ; pour le transistor Q4 la source de courant est un transistor MOS M4 connecté entre l'émetteur de Q4 et la masse M et fournissant un courant 14 ; ce transistor M4 a sa base commandée par le même potentiel Vgn que le transistor M2. Les transistors M2 et M4 sont homothétiques, de sorte que les courants 12 et 14 sont dans le même rapport que les tailles des transistors M2 et M4. Ces transistors M2 et M4 pourraient aussi être des transistors bipolaires.

Le circuit fonctionne de la manière qui va maintenant être expliquée.

Pour les alternances positives du signal différentiel à amplifier (en prenant la référence de signal positif de la manière suivante : tension plus élevée sur l'entrée E, moins élevée sur l'entrée E', autour du potentiel de mode commun Vmc), on tend à mettre en conduction le transistor de sortie Q1 par l'intermédiaire du transistor suiveur Q2. Dans le même temps, le transistor Q4 tend à se bloquer, le courant dans le transistor Q3 décroît et ne s'oppose donc pas à l'augmentation de la conduction du transistor de sortie.

La situation est différente pour les alternances négatives du signal à amplifier. Lorsque la tension sur E diminue et la tension sur E' augmente, le courant de base du transistor de sortie Q1 tend à diminuer et le courant de collecteur de ce transistor Q1 décroît également. La capacité d'entrée du transistor Q1 est relativement élevée et tend à s'opposer à cette baisse du courant de base de Q1. Mais la présence du transistor Q3, qui devient plus conducteur du fait de sa commande par le transistor Q4, aide à diminuer le courant de base du transistor Q1.

Le potentiel de mode commun Vmc (compté par rapport à la masse M), autour duquel varient les potentiels sur E et E', peut être de l'ordre de deux fois une tension base-émetteur de transistor (par exemple 1,3 volt).

Le transistor de sortie Q1 a une taille suffisante pour laisser passer tout le courant de sortie désiré, par exemple un courant de quelques centaines de milliampères. Les tailles du transistor Q2 et du transistor Q3 sont beaucoup plus faibles puisqu'ils doivent conduire un courant de l'ordre du courant nécessaire à la commande de la base de Q1. Le rapport N entre la taille du transistor Q1 et le transistor Q3 est de préférence inférieur à la racine carrée du gain en courant du transistor Q1.

La commande du transistor Q3 se fait par l'intermédiaire du transistor Q4 de la même manière que la commande du transistor Q1 se fait par l'intermédiaire du transistor Q2 : le transistor Q3 est monté en émetteur commun et commandé par le transistor Q4 monté en suiveur, de même que le transistor Q1 est monté en émetteur commun et commandé par le transistor Q2 monté en suiveur. Le rapport entre la taille du transistor Q2 et celle du transistor Q4 est en principe égal au rapport N entre la taille de Q1 et celle de Q3 pour que les courants soient homothétiques. Le rapport entre les courants 12 et 14 est le même rapport N, et le rapport entre les tailles des transistors M2 et M4 est aussi le même, ces transistors ayant leur grille commandée par le même potentiel Vgn.

L'impédance d'entrée vue du point E (entrée sur la base de Q2) n'est pas a priori la même que celle vue du point E' (entrée sur la base de Q4) car le transistor Q4 n'est a priori chargé que par le transistor Q3 et la source de courant 14, alors que le transistor Q2 est chargé à la fois par le transistor Q1, la source de courant 12 et le transistor Q3. C'est pourquoi on prévoit de préférence le rajout d'un transistor auxiliaire Q5, disposé vis-à-vis du transistor Q4 de la même manière que le transistor Q3 est disposé par rapport au transistor Q2. Le transistor Q5 a son émetteur chargé par une résistance d'émetteur R5, son collecteur relié à l'émetteur de Q4, et sa base est commandée par un potentiel V'mc constant égal au potentiel moyen sur la base de Q1.

La taille du transistor Q5 est N fois plus faible que la taille du transistor Q3, elle-même N fois plus faible que celle de Q1. La résistance d'émetteur R5 est N fois plus forte que la résistance R3, elle-même N fois plus forte que la résistance R1.

Il en résulte que le transistor Q5 est NxN fois plus petit que le transistor Q1. Le rapport N sera choisi de manière que le transistor Q5 ne soit pas plus petit que ce que permet la technologie compte tenu de la taille choisie pour le transistor Q1. Par exemple un rapport N = 8 ou N =16 pourra convenir pour un amplificateur dont le transistor de sortie permet de fournir un courant de 300 milliampères. Ceci suppose, comme on l'a dit précédemment, que le gain en courant du transistor de sortie Q1 soit au moins égal à N², c'est-à-dire à 64 ou 256, ce qui ne pose pas de problème particulier.

Avec le transistor Q5 ainsi correctement dimensionné, on a une égalité structurelle des densités de courant qui garantit une excellente indépendance du fonctionnement vis-à-vis des variations de paramètres technologiques.

En effet, les choix de dimensions de transistors et de transistors auxiliaires permettent de s'assurer que les points de polarisation des transistors sont identiques et qu'une même variation de tension base-émetteur sur deux transistors homothétiques engendre des variations de courants homothétiques dans le rapport des tailles des transistors. Cependant, Mais en haute fréquence interviennent en outre les capacités des transistors. Or les courants d'entrée sur E et E' sont différents et les capacités vues sur ces entrées sont différentes. La capacité d'un gros transistor est plus grande que celle d'un petit transistor, de sorte que la capacité vue de l'entrée E est beaucoup plus grande que la capacité vue de l'entrée E' (dans le rapport N).

Or le fonctionnement correct de l'étage amplificateur suppose en principe que les signaux présents sur E et E' sont véritablement en opposition de phase, faute de quoi le rendement de l'amplificateur peut chuter de manière importante (plusieurs pourcents de rendement perdus pour un décalage de phase de quelques degrés) ; mais la présence de capacités d'entrée différentes tend à empêcher une exacte opposition de phase, dans la mesure où l'impédance de sortie de l'étage qui est situé en amont des entrées E et E' n'est pas infiniment faible.

Par conséquent, on essaie de résoudre ce problème sans exiger une impédance de sortie extrêmement faible en amont des entrées E et E'. Pour cela, on dédouble l'étage d'amplification en un premier demi-étage A1 et un deuxième demi-étage A2 qui reçoivent les mêmes entrées mais croisées de manière à agir rigoureusement en opposition de phase. Ainsi, l'un des signaux d'entrée sera appliqué simultanément au transistor Q2 de l'étage A1 et au transistor Q4 de l'étage A2, tandis que l'autre signal d'entrée, en opposition de phase avec le premier, sera appliqué au transistor Q4 de l'étage A1 et au transistor Q2 de l'étage A2. Les sorties des deux amplificateurs, en opposition de phase puisqu'on a croisé leurs entrées, seront remises en phase avant d'être additionnées (en courant) pour constituer une sortie unique d'amplificateur. Avec cette construction en deux-demi-étages symétriques, on résout le problème de la dissymétrie des capacités d'entrée puisque chaque entrée E ou E' voit maintenant en parallèle à la fois un gros transistor (Q2) de l'un des demi-étages et un petit transistor (Q4) de l'autre demi-étage.

Les demi- étages A1 et A2 utilisent des transistors deux fois plus petits que s'il n'y avait qu'un seul étage, pour un courant de sortie final déterminé, donc pour une puissance d'amplicateur déterminée.

La figure 2 représente la constitution de l'amplificateur ainsi dédoublé. Dans la réalisation représentée, on a supposé qu'il y avait un étage préamplificateur commun PA recevant un signal d'entrée différentiel à amplifier. Ce signal d'entrée est appliqué entre deux entrées In et In'. Le préamplificateur fournit une sortie différentielle en deux points E et E' avec une tension de mode commun Vmc qui est réglée par la polarisation des transistors de sortie du préamplificateur. L'étage d'amplification principal comprend deux demi-amplificateurs identiques A1 et A2 constitués chacun comme à la figure 1. On considère que ces étages ont chacun une première entrée non-inverseuse, repérée par le signe positif + et une deuxième entrée repérée par le signe négatif - . Par exemple, l'entrée + est celle qui correspond à la base du transistor Q2 tandis que l'entrée - est celle qui correspond à la base du transistor Q4.

Les demi-amplificateurs ont leurs entrées croisées, c'est-à-dire que le point E est connecté à l'entrée + de l'étage A1 et à l'entrée - de l'étage A2, alors qu'inversement le point E' est relié à l'entrée - de l'étage A1 et à l'entrée + de l'étage A2.

L'étage A1 a une sortie S1 qui est une borne extérieure du circuit-intégré. L'étage A2 a une sortie semblable S2, qui est une autre borne extérieure du circuit intégré. Le circuit intégré comprend les deux étages A1 et A2 et le préamplificateur PA et éventuellement d'autres éléments non représentés. Les sorties S1 et S2 fournissent des courants en opposition de phase. Ces courants sont additionnés à l'extérieur du circuit intégré, après avoir été remis en phase.

Cette remise en phase et cette addition peuvent être réalisée par différents moyens : transformateur à enroulements convenablement orientés (pour des fréquences peu élevées), ou coupleur hybride (pour des fréquences plus élevées), ou encore lignes couplées électromagnétiquement (pour des fréquences très élevées). Ces éléments réalisent en même temps une adaptation d'impédance pour adapter l'impédance de sortie de l'amplificateur à l'impédance de la charge à alimenter, dans le cas où le transistor de sortie d'un étage A1 ou A2 fonctionne de manière optimale à une impédance de sortie qui n'est pas égale à l'impédance de la charge.

Sur la figure 2, on a représenté un coupleur hybride CH à inductances et capacités, dont les deux entrées sont connectées aux bornes de sortie S1 et S2 et dont la sortie est constituée par une borne OUT et la masse. La sortie OUT fournit la somme des courants de sortie des amplificateurs A1 et A2, remis en phase.

Cette sortie OUT peut-être connectée directement à une antenne radio dans une application d'émission radio à faible puissance. La charge peut-être de 50 ohms, la fréquence de 917 MHz ou plus, et l'alimentation peut être de 2,4 à 3 volts si le circuit intégré est réalisé en technologie BiCMOS sur silicium.

On remarquera qu'avec cette constitution avec deux courants de sortie en opposition de phase, l'amplificateur émet un rayonnement parasite moindre que s'il n'y avait qu'une seule sortie. En effet, les demi-courants en opposition de phase tendent à annuler leurs rayonnements propres.

Le schéma d'amplificateur selon l'invention permet entre autres de fournir une puissance relativement indépendante des variations de la tension d'alimentation Vcc, ce qui est utile dans des applications fonctionnant sur batterie ou piles pour lesquelles la tension d'alimentation tend à baisser (du fait de la résistance interne de la batterie ou de la pile) lorsque l'amplificateur fonctionne à pleine puissance.

L'absence d'éléments accordés dans le circuit intégré permet que l'amplificateur fonctionne dans une large gamme de fréquences. Seuls les éléments extérieurs (ceux du coupleur hybride par exemple) seront déterminés en fonction de la fréquence de travail désirée.

Pour polariser l'entrée des demi-amplificateurs A1 et A2 à une tension de mode commun d'entrée Vmc relativement indépendante de la température et des variations technologiques, on peut utiliser un circuit auxiliaire qui agit sur la polarisation de la sortie du préamplificateur PA. Pour cela, on peut réaliser sur le même circuit intégré un amplificateur auxiliaire identique aux étages amplificateurs A1 et A2 mais de taille réduite (tous les transistors étant homothétiques de ceux de A1 et A2). Cet amplificateur aura pour entrée une tension de mode commun Vmc (pas de signal différentiel en entrée de l'amplificateur auxiliaire) qui sera utilisée pour constituer la polarisation de la sortie du préamplificateur. Cette tension de mode commun sera asservie de telle manière que le courant de repos dans l'amplificateur auxiliaire (et par conséquent dans les amplificateurs A1 et A2) soit rendu stable, au premier ordre, malgré les variations de température, de tension d'alimentation et de technologie. La stabilité de courant de repos obtenue pour l'amplificateur auxiliaire par une action sur le potentiel Vmc engendrera une stabilité analogue des courants de repos des amplificateurs A1 et A2 polarisés par la même tension de mode commun Vmc.

Le circuit intégré peut fonctionner même avec une tension d'alimentation aussi basse que 2,2 volt étant donné le faible nombre de jonctions en série entre l'alimentation Vcc et la masse.

Le circuit intégré qui comporte l'amplificateur selon l'invention peut avoir ou non des entrées extérieures pour un signal à amplifier. C'est le cas si le circuit intégré a une fonction d'amplificateur d'un signal. Ce n'est pas le cas si c'est par exemple un synthétiseur de fréquence ayant comme entrée un oscillateur formé sur la même puce de circuit intégré.

## Revendications

1. Circuit intégré comportant un amplificateur dont le dernier étage comprend deux points d'entrée de signal à amplifier E et E' recevant en différentiel un signal à amplifier, et quatre transistors principaux de même type de conductivité, ayant chacun une base, un émetteur et un collecteur, parmi lesquels un premier transistor ou transistor de sortie (Q1) monté en émetteur commun, dont le collecteur est relié à une sortie (S) du circuit intégré, un deuxième transistor (Q2) monté en suiveur de tension entre le point E et la base du transistor de sortie (Q1), un troisième transistor (Q3) monté en émetteur commun, ayant son collecteur relié à la base du transistor de sortie (Q1) **caractérisé en ce qu'**il comporte en outre un quatrième transistor (Q4) monté en suiveur de tension ayant sa base reliée au point E' et son émetteur relié à la base du troisième transistor (Q3), une première source de courant (M2) reliée à la base du premier transistor (Q1) et une deuxième source de courant (M4) reliée à la base du troisième transistor (Q3).

2. Circuit intégré selon la revendication 1, **caractérisé en ce que** les quatre transistors sont tous des transistors bipolaires.

3. Circuit intégré selon l'une des revendications 1 et 2, **caractérisé en ce que** la taille du transistor de sortie (Q1) est N fois plus grande que celle du troisième transistor (Q3).

4. Circuit intégré selon la revendication 3, **caractérisé en ce que** la taille du deuxième transistor (Q2) est dans le même rapport N avec le quatrième transistor (Q4).

5. Circuit intégré selon la revendication 4, **caractérisé en ce que** les première et deuxième sources de courant fournissent des courants dans le même rapport N.

6. Circuit intégré selon l'une des revendications 3 à 5, **caractérisé en ce qu'**il est prévu une résistance d'émetteur (R1) entre l'émetteur du transistor de sortie (Q1) et une masse (M), et une résistance d'émetteur (R3) entre l'émetteur du troisième transistor et la masse (M), la résistance d'émetteur (R1) du transistor de sortie étant N fois plus faible que la résistance d'émetteur (R3) du troisième transistor.

7. Circuit intégré selon l'une des revendications 1 à 5, **caractérisé en ce qu'**il comporte un cinquième transistor (Q5), ayant sa base polarisée par une tension fixe (Vmc), son émetteur relié à la masse par une résistance d'émetteur (R5), et son collecteur relié à la base du troisième transistor (Q3).

8. Circuit intégré selon la revendication 7, **caractérisé en ce que** le cinquième transistor (Q5) a une taille plus faible que celle du troisième transistor (Q3), dans le même rapport que le rapport des tailles des premier et troisième transistors.

9. Circuit intégré **caractérisé en ce qu'**il comporte deux demi-amplificateurs (A1, A2) selon l'une des revendications 1 à 8, recevant des signaux d'entrée identiques et en opposition de phase et ayant deux sorties reliées par un circuit de couplage (CH) apte à additionner les courants de sortie, remis en phase, des demi-amplificateurs.

10. Circuit intégré selon la revendication 9, **caractérisé en ce que** les sorties des demi-amplificateurs sont des sorties du circuit intégré et **en ce que** le circuit de couplage (CH) est extérieur au circuit intégré.

## Claims

1. Integrated circuit comprising an amplifier whose final stage comprises two signal amplification input points E and E' receiving in differential mode a signal to be amplified, and four main transistors of the same type of conductivity, each having a base, an emitter and a collector, including a first transistor or output transistor (Q1) mounted in common emitter configuration, whereof the collector is linked to an output (S) of the integrated circuit, a second transistor (Q2) mounted in voltage follower configuration between the point E and the base of the output transistor (Q1), a third transistor (Q3) mounted in common emitter configuration, having its collector linked to the base of the output transistor (Q1), **characterized in that** it also comprises a fourth transistor (Q4) mounted in voltage follower configuration having its base linked to the point E' and its emitter linked to the base of the third transistor (Q3), a first current source (M2) linked to the base of the first transistor (Q1) and a second current source (M4) linked to the base of the third transistor (Q3) .

2. Integrated circuit according to Claim 1,
**characterized in that** the four transistors are all bipolar transistors.

3. Integrated circuit according to either of Claims 1 and 2, **characterized in that** the size of the output transistor (Q1) is N times greater than that of the third transistor (Q3).

4. Integrated circuit according to Claim 3,
**characterized in that** the size of the second transistor (Q2) is in the same ratio N with the fourth transistor (Q4).

5. Integrated circuit according to Claim 4,
**characterized in that** the first and second current sources supply currents in the same ratio N.

6. Integrated circuit according to one of Claims 3 to 5, **characterized in that** an emitter resistance (R1) is provided between the emitter of the output transistor (Q1) and a ground (M), and an emitter resistance (R3) is provided between the emitter of the third transistor and the ground (M), the emitter resistance (R1) of the output transistor being N times smaller than the emitter resistance (R3) of the third transistor.

7. Integrated circuit according to one of Claims 1 to 5, **characterized in that** it includes a fifth transistor (Q5), having its base biased by a fixed voltage (Vmc), its emitter linked to the ground via an emitter resistance (R5), and its collector linked to the base of the third transistor (Q3).

8. Integrated circuit according to Claim 7,
**characterized in that** the fifth transistor (Q5) has a size smaller than that of the third transistor (Q3), in the same ratio as the ratio of the sizes of the first and third transistors.

9. Integrated circuit **characterized in that** it comprises two half-amplifiers (A1, A2) according to one of Claims 1 to 8, receiving input signals that are identical and in phase opposition and having two outputs linked by a coupling circuit (CH) designed to add the output currents, phase realigned, of the half-amplifiers.

10. Integrated circuit according to Claim 9,
**characterized in that** the outputs of the half-amplifiers are outputs of the integrated circuit and **in that** the coupling circuit (CH) is external to the integrated circuit.

## Patentansprüche

1. Integrierte Schaltung, mit einem Verstärker, dessen letzte Stufe zwei Eingangspunkte E und E' für das zu verstärkende Signal enthält, die ein zu verstärkendes Signal differentiell empfangen, und vier Haupttransistoren desselben Leitfähigkeitstyps, wovon jeder eine Basis, einen Emitter und einen Kollektor besitzt, unter denen ein erster Transistor oder Ausgangstransistor (Q1) eine Emitterschaltung ist, deren Kollektor mit einem Ausgang (S) der integrierten Schaltung verbunden ist, ein zweiter Transistor (Q2) eine Spannungsfolgerschaltung zwischen dem Punkt E und der Basis des Ausgangstransistors (Q1) ist und ein dritter Transistor (Q3) eine Emitterschaltung ist, deren Kollektor mit der Basis des Ausgangstransistors (Q1) verbunden ist, **dadurch gekennzeichnet, dass** sie außerdem enthält: einen vierten Transistor (Q4), der eine Spannungsfolgerschaltung ist, deren Basis mit dem Punkt E' verbunden ist und deren Emitter mit der Basis des dritten Transistors (Q3) verbunden ist, eine erste Stromquelle (M2), die mit der Basis des ersten Transistors (Q1) verbunden ist, und eine zweite Stromquelle (M4), die mit der Basis des dritten Transistors (Q3) verbunden ist.

2. Integrierte Schaltung nach Anspruch 1, **dadurch gekennzeichnet, dass** alle vier Transistoren Bipolartransistoren sind.

3. Integrierte Schaltung nach einem der Ansprüche 1 und 2, **dadurch gekennzeichnet, dass** die Größe des Ausgangstransistors (Q1) N mal größer als jene des dritten Transistors (Q3) ist.

4. Integrierte Schaltung nach Anspruch 3, **dadurch gekennzeichnet, dass** die Größe des zweiten Transistors (Q2) im gleichen Verhältnis N zu jener des vierten Transistors (Q4) steht.

5. Integrierte Schaltung nach Anspruch 4, **dadurch gekennzeichnet, dass** die erste und die zweite Stromquelle Ströme im gleichen Verhältnis N liefern.

6. Integrierte Schaltung nach einem der Ansprüche 3 bis 5, **dadurch gekennzeichnet, dass** ein Emitterwiderstand (R1) zwischen dem Emitter des Ausgangstransistors (Q1) und Masse (M) und ein Emitterwiderstand (R3) zwischen dem Emitter des dritten Transistors und Masse (M) vorgesehen sind, wobei der Emitterwiderstand (R1) des Ausgangstransistors N mal kleiner als der Emitterwiderstand (R3) des dritten Transistors ist.

7. Integrierte Schaltung nach einem der Ansprüche 1 bis 5, **dadurch gekennzeichnet, dass** sie einen fünften Transistor (Q5) enthält, dessen Basis durch eine feste Spannung (Vmc) vorgespannt ist, dessen Emitter über einen Emitterwiderstand (R5) mit Masse verbunden ist und dessen Kollektor mit der Basis des dritten Transistors (Q3) verbunden ist.

8. Integrierte Schaltung nach Anspruch 7, **dadurch gekennzeichnet, dass** der fünfte Transistor (Q5) eine Größe hat, die kleiner als jene des dritten Transistors (Q3) ist, und zwar im selben Verhältnis wie das Verhältnis der Größen des ersten und des dritten Transistors.

9. Integrierte Schaltung, **dadurch gekennzeichnet, dass** sie zwei Halbverstärker (A1, A2) nach einem der Ansprüche 1 bis 8 enthält und übereinstimmende Eingangssignale mit entgegengesetzter Phase empfängt und zwei Ausgänge besitzt, die durch eine Kopplungsschaltung (CH) verbunden sind, die die Ausgangsströme mit zurückgesetzter Phase der Halbverstärker addieren kann.

10. Integrierte Schaltung nach Anspruch 9, **dadurch gekennzeichnet, dass** die Ausgänge der Halbverstärker Ausgänge der integrierten Schaltung sind und dass sich die Kopplungsschaltung (CH) außerhalb der integrierten Schaltung befindet.
